# EUROPEAN PATENT APPLICATION

(11) **EP 1 505 860 A1**
(43) Date of publication of application: **09.02.2005**
(21) Application number: 04018473.1
(22) Date of filing: 04.08.2004
(51) Int. Cl.: H05K 5/00, H05K 5/03

(54) **Surface mounted electronic circuit module**

(30) Priority: 08.08.2003 JP 2003290954
(71) Applicant: ALPS ELECTRIC CO., LTD., Tokyo 145-8501 (JP)
(72) Inventor: Yatsu, Hiroyuki, Alps Electric Co.Ltd, Tokyo 145-8501 (JP)
(74) Representative: Klunker . Schmitt-Nilson . Hirsch

(57) **Abstract**

The present invention provides an electronic circuit module having a certainty of soldering attachment to a motherboard, a small size and a highly reliable connection to the motherboard. An electronic circuit module of the present invention comprises a circuit board (1) formed with laminated plurality of insulating sheets, and a cover (9) made from a metal plate and having attaching legs (9c) soldered to electrode portions (8) in the concave portions (1c) in a state of covering the electronic component (7). The concave portions (1c) are formed from an upper surface of the circuit board (1) toward a lower surface side, stopping portions (1d) for plugging the lower portions of the concave portions (1c) are provided in the circuit board (1), and the attaching legs (9c) of the cover (9) are soldered to the electrode portions (8) in a state of being inserted into the concave portions (1c). As a result, it is possible to prevent the soldering connecting the attaching legs (9c) to the electrode portions (8) from leaking downward by way of the stopping portions (1d). Accordingly, the degree of flatness of the circuit board (1) to the motherboard (10) becomes better and the soldering is reliable.

## Description

### BACKGROUND OF THE INVENTION

### 1. Field of the Invention

The present invention relates to an electronic circuit module that is suitably used for a voltage controlled oscillator, and the like.

### 2. Description of the Related Art

Referring to drawings of a conventional electronic circuit module, Fig. 12 is a perspective view of the conventional electronic circuit module, Fig. 13 is a perspective view of a circuit board according to the conventional electronic circuit module, and Fig. 14 is an explanation view showing a fabricating method of the circuit board according to the conventional electronic circuit module.

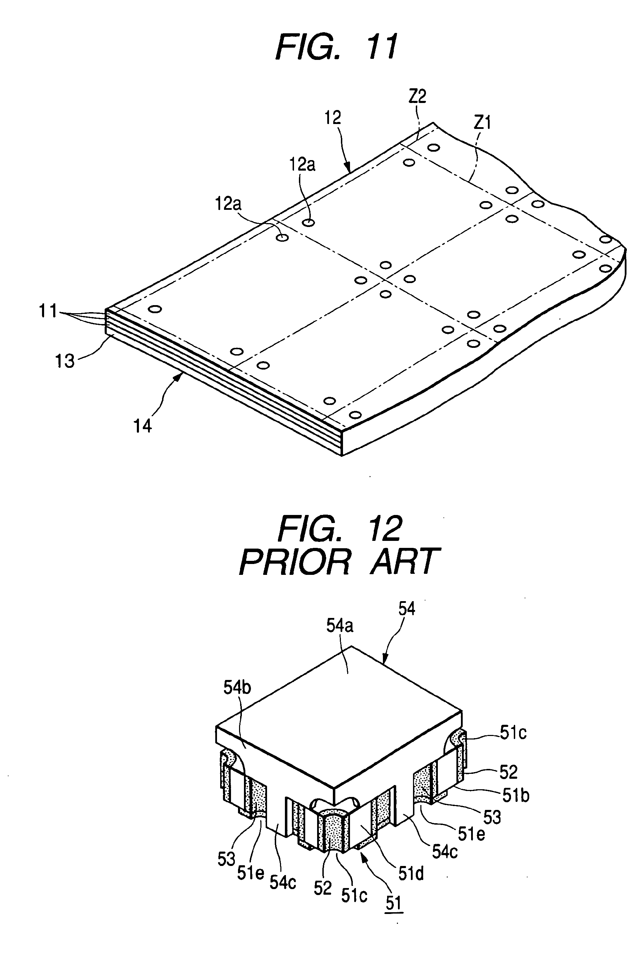

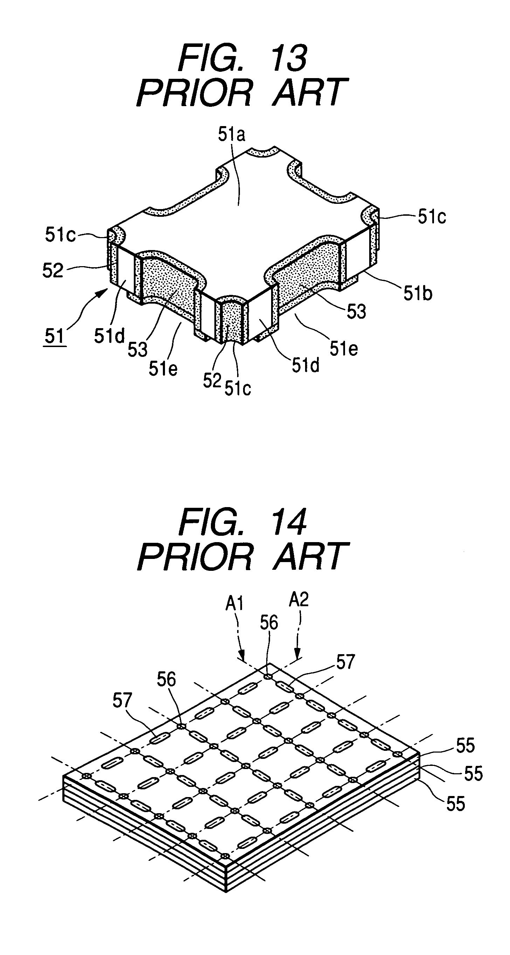

Then, referring to Figs. 12 and 13 to explain a structure of the conventional electronic circuit module, a rectangular circuit board 51 formed with laminated plurality of insulating sheets has a first-concave portion 51c with a notch provided in a corner portion, that passes through from an upper surface 51a to a lower surface 51b, and a second concave portion 51e with a notch provided in a side surface 51d.

A first electrode portion 52 is formed on an inner wall of the first concave portion 51c, which is a side electrode portion, and a second electrode portion 53 is formed on an inner wall of the second concave portion 51e.

Then, a wiring pattern, which is not shown in the drawing, is formed on the upper surface 51a of the circuit board 51. Further, the wiring patterns are connected to the first and second electrode portions 52 and 53, and various electronic components are mounted thereon, whereby a desired electric circuit is formed.

A box-shaped cover 54 made from a metal plate has an upper surface plate 54a, four side surface plate 54b which are bent downward from four sides of the upper surface plate 54a, and four attaching legs 54c extending downward from the four side surface plate 54b.

With the cover 54 covering the upper surface 51a (electronic component) of the circuit board 51, the attaching legs 54c are inserted into the second concave portions 51e, the lower edges of the side surface plates 54b are abutted to the upper surface 51a, and the attaching legs 54c are soldered to the second electrode portion 53, whereby the cover 54 is attached to the circuit board 51 (See Japanese Unexamined Patent Application Publication No. 10-284935).

At this time, since the second concave portion 51e is provided in a state of passing through vertically, a soldering for connecting the attaching legs 54c to the second electrode portions 53 hangs downward from the lower surface 51b of the circuit board 51, so that the soldering is in a state of protruding downward from the lower surface 51b.

Further, since the first and second concave portions 51c and 51e are provided, an area of the lower surface 51b of the circuit board 51 becomes small, and then an area for forming the wiring patterns should be larger, whereby the module has a large size.

In the electronic circuit module having such a structure, the lower surface of the circuit board 51 is positioned on a motherboard (not shown) and the first electrode portion 52 is connected to a circuit of the motherboard.

However, when the circuit board 51 is positioned on the motherboard, the soldering for connecting the attaching legs 54c to the second electrode portions 53 is in a state of protruding downward from the lower surface 51b. As a result, a flatness of the circuit board 51 to the motherboard is bad, and the soldering may be unreliable.

Further, Fig. 14 shows a method for fabricating the - circuit board 51 according to the conventional electronic circuit module. Firstly, while laminating a plurality of insulating sheets 55, circular-shaped through holes 56 forming the first concave portions 51c and elliptical-shaped through holes 57 forming the second concave portions 51e are formed.

Then, the insulating sheets 55 are cut along the lines A1 and A2 disposed on the through holes 56 and 57, so that a plurality of circuit boards 51 having the first and second concave portions 51c and 51e is fabricated (See Japanese Unexamined Patent Application Publication No. 10-284935).

In the conventional electronic circuit module, since the second concave portions 51e, formed in the circuit board 51, into which the attaching legs 54c of the cover 54 are inserted, are formed to pass through vertically, the soldering for connecting the attaching legs 54c to the second electrode portions 53 protrudes downward from the lower surface 51b. For this reason, there are problems in that the flatness of the circuit board 51 to the motherboard becomes bad, and the soldering may be unreliable.

Further, since the first and second concave portions 51c and 51e are provided on the circuit board 51, there are problems in that the area of the lower surface 51b of the circuit board 51 becomes small, and the area for forming the wiring patterns should be larger, thereby making the module have a large size.

### SUMMARY OF THE INVENTION

Therefore, it is an object of the present invention to provide an electronic circuit module that secures the soldering to the motherboard, has a small size, and has a high reliability of the connection to the motherboard.

As a first aspect for solving the problems, the present invention provide an electronic circuit module comprising: a circuit board formed with laminated plurality of insulating sheets, on an upper surface on which wiring patterns are formed; an electronic component mounted on an upper surface of the circuit board; concave portions provided in the circuit board; electrode portions provided on inner walls of the concave portions; and a cover made from a metal plate and having attaching legs soldered to the electrode portions in the concave portions in a state of covering the electronic component, wherein the concave portions are formed toward a lower surface side from the upper surface of the circuit board, stopping portions for plugging the lower portions of the concave portions are provided in the circuit board, and the attaching legs of the cover are soldered to the electrode portions in a state of being inserted into the concave portions.

As a second aspect for solving the problems, the concave portions are formed with notches provided in a side surface on an outer circumference of the circuit board.

As a third aspect for solving the problems, the outside surfaces of the stopping portions for plugging the lower portions of the concave portions are flush with the side surface of the circuit board.

As a fourth aspect for solving the problems, the concave portions are formed with non-through holes provided inboard from the side surface of the circuit board.

As a fifth aspect for solving the problems, the circuit board comprises a first board portion having the concave portions which pass through the circuit board vertically, and a second board portion, on which the stopping portions are provided, having body portions at positions corresponding to the lower portions of the concave portions, and the circuit board is made by laminating the first board portion and the second board portion.

As a sixth aspect for solving the problems, a connection conductor connected to the wiring patterns are provided on the lower surface of the circuit board, and the circuit board is connected to a circuit on a motherboard via the connection conductor in a state of being mounted on the motherboard. As a seventh aspect for solving the problems, the circuit board comprises a blind via hole and an electric conductor provided in an inner wall of the blind via hole, and the wiring patterns formed at different lamination positions are connected to each other via the electric conductor.

The electronic circuit module of the present invention comprises a circuit board formed with laminated plurality of insulating sheets, on an upper surface of which wiring patterns are provided; an electronic component mounted on an upper surface of the circuit board; concave portions provided in the circuit board; electrode portions provided on inner walls of the concave portions; and a cover made from a metal plate and having attaching legs soldered to the electrode portions in the concave portions in a state of covering the electronic component, wherein the concave portions are formed toward a lower surface side from the upper surface of the circuit board, stopping portions for plugging the lower portions of the concave portions are provided in the circuit board, and the attaching legs of the cover are soldered to the electrode portions in a state of being inserted into the concave portions.

As described above, when the stopping portions for plugging the lower portions of the concave portions are provided, the soldering connecting the attaching legs to the electrode portions is prevented from leaking downward by the stopping portions, and then the flatness of the circuit board to the motherboard improves, and the soldering becomes reliable.

Further, by providing the stopping portions, an area of the lower surface of the circuit board increases, and an area for forming the wiring patterns decreases. Therefore, miniaturization can be achieved, and the gap of the connection conductor for connection to a circuit of the motherboard can be large, thereby providing an electronic circuit module having a highly reliable connection.

Further, since the concave portions are formed with the notches provided on the side surface on the outer circumference of the circuit board, the circuit board can be small, so that one suitable for miniaturization can be obtained.

Further, the outside surfaces of the stopping portions for plugging the lower portions of the concave portions are flush with the side surface of the circuit board, and thus a circuit board capable of being easily fabricated and suitable for mass production can be obtained.

Further, the concave portions are formed with the non-through holes provided inboard from the side surface of the circuit board, so that the circuit board can be large and the gap of the connection conductor for the connection to the circuit of the motherboard can be increased, whereby the electronic circuit module having a highly reliable connection can be provided.

Further, the circuit board comprises the first board portion having concave portions which pass through vertically and the second board portion, on which the stopping portions are provided, having the body portions at the positions corresponding to the lower portions of the concave portions, wherein the circuit board is made by laminating the first board portion and the second board portion. Accordingly, a circuit board being easily fabricated, having good productivity and suitable for mass production can be obtained.

Further, since the connection conductor connected to the wiring patterns is provided on the lower surface of the circuit board, and the circuit board is connected to the circuit on the motherboard by the connection conductor in a state of being mounted on the motherboard, a connection to the motherboard by way of a side electrode portion can be eliminated. As a result, the lower surface of the circuit board becomes large, and then the miniaturization is achieved. Further, the gap of the connection conductor for the connection to the circuit of the motherboard can be large, and then the electronic circuit module having a highly reliable connection can be provided.

Further, the circuit board has a blind via hole and an electric conductor provided at the inner wall of the blind via hole, and the wiring patterns formed at different lamination positions are connected to each other by way of the electric conductor, so that the connection structure is simple, and the reliable connection can be achieved.

### BRIEF DESCRIPTION OF THE DRAWINGS

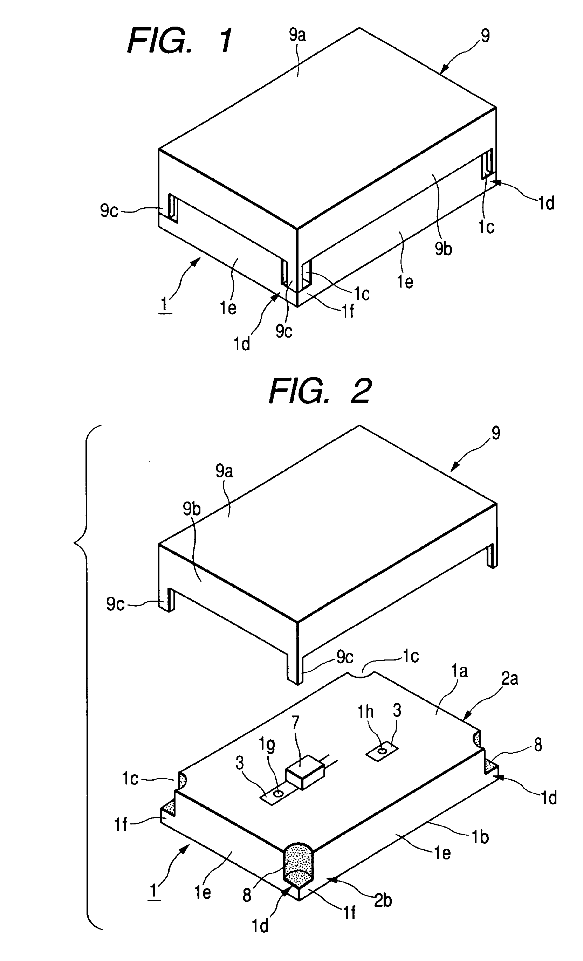

Fig. 1 is a perspective view of an electronic circuit module according to a first embodiment of the present invention;
Fig. 2 is an exploded perspective view of the electronic circuit module according to the first embodiment of the present invention;

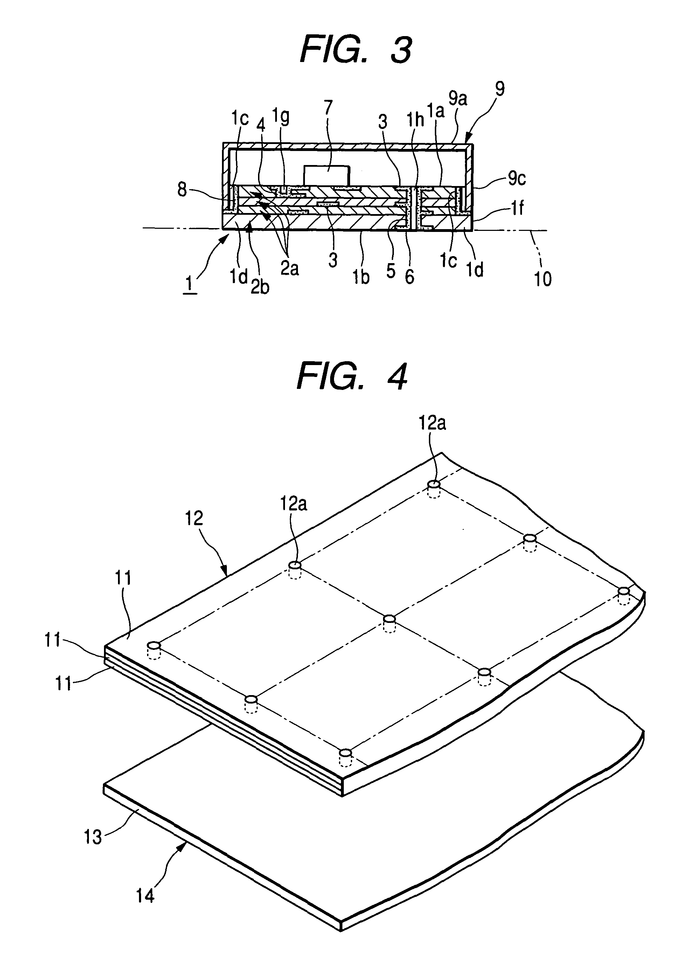

Fig. 3 is a cross-sectional view of a main part of the electronic circuit module according to the first embodiment of the present invention;
Fig. 4 is an explanation view showing a first process of a method for fabricating a circuit board, according to the first embodiment of the electronic circuit module of the present invention;

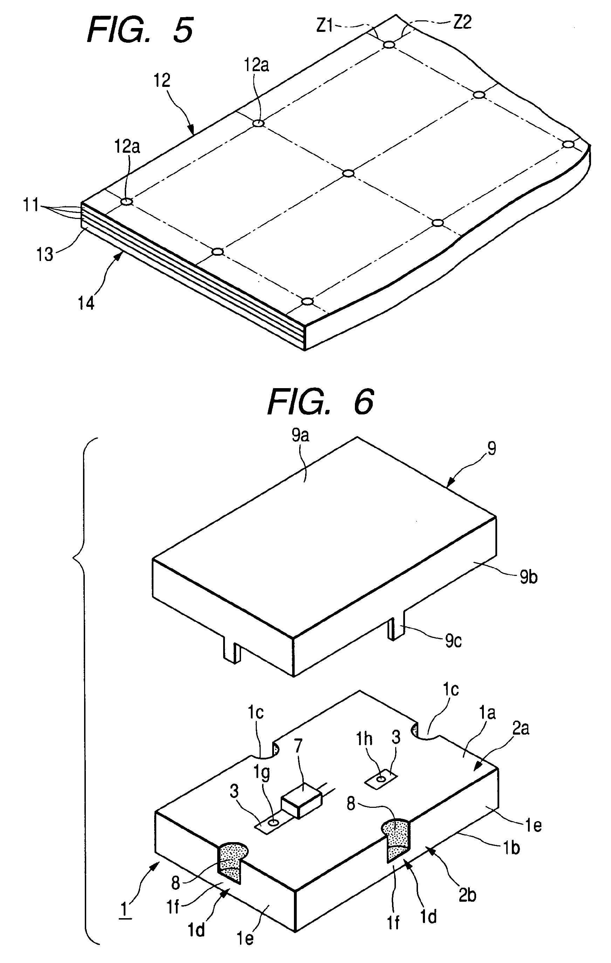

Fig. 5 is an explanation view showing a second process of a method for fabricating the circuit board, according to the first embodiment of the electronic circuit module of the present invention;
Fig. 6 is an exploded perspective view of the electronic circuit module according to a second embodiment of the present invention;

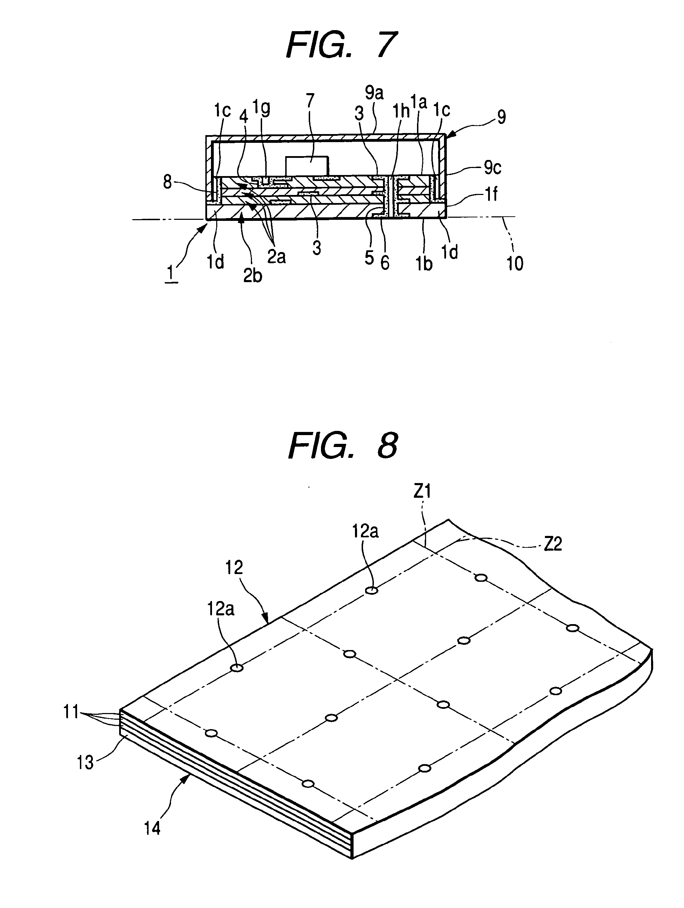

Fig. 7 is a cross-sectional view of a main part of the electronic circuit module according to the second embodiment of the present invention;
Fig. 8 is an explanation view showing a method for fabricating the circuit board, according to the second embodiment of the electronic circuit module of the present invention;

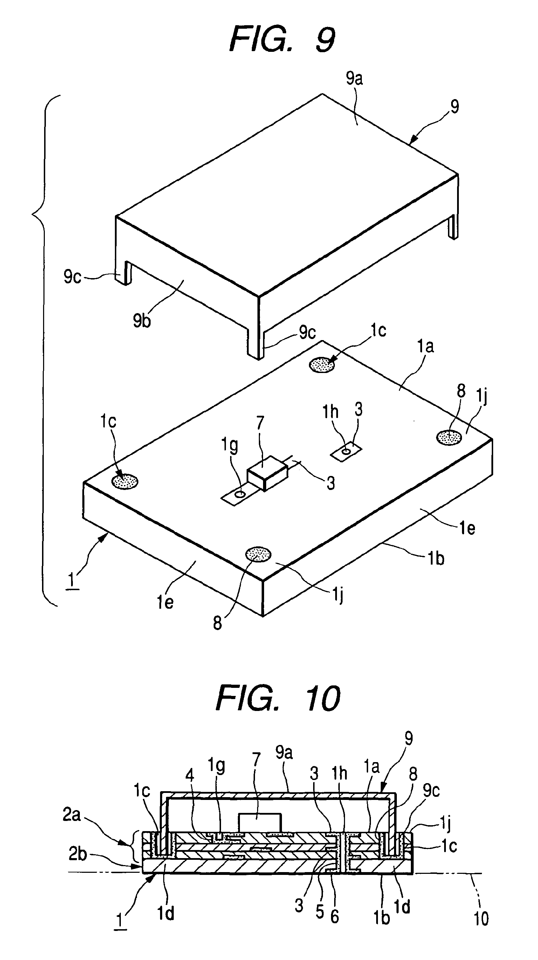

Fig. 9 is an exploded perspective view of the electronic circuit module according to a third embodiment of the present invention;
Fig. 10 is a cross-sectional view of a main part of the electronic circuit module according the third embodiment of the present invention;
Fig. 11 is an explanation view showing a method for fabricating the circuit board, according to the third embodiment of the electronic circuit module of the present invention;
Fig. 12 is a perspective view of a conventional electronic circuit module;
Fig. 13 is a perspective view of a circuit board according to the conventional electronic circuit module; and
Fig. 14 is an explanation view showing a method for fabricating the circuit board, according to the conventional electronic circuit module.

### DETAILED DESCRIPTION OF THE EMBODIMENTS

Hereinafter, an electronic circuit module of the present invention will be now described with reference to the accompanying drawings. Fig. 1 is a perspective view of the electronic circuit module according to a first embodiment of the present invention. Fig. 2 is an exploded perspective view of the electronic circuit module according to the first embodiment of the present invention, Fig. 3 is a cross-sectional view of a main part of the electronic circuit module according to the first embodiment of the present invention, Fig. 4 is an explanation view showing a first process of a method for fabricating a circuit board, according to the first embodiment of the electronic circuit module of the present invention, and Fig. 5 is an explanation view showing a second process of a method for fabricating the circuit board, according to the first embodiment of the electronic circuit module of the present invention.

Further, Fig. 6 is an exploded perspective view of the electronic circuit module according to a second embodiment of the present invention, Fig. 7 is a cross-sectional view of a main part of the electronic circuit module according to the second embodiment of the present invention, and Fig. 8 is an explanation view showing a method for fabricating the circuit board, according to the second embodiment of the electronic circuit module of the present invention.

Further, Fig. 9 is an exploded perspective view of the electronic circuit module according to a third embodiment of the present invention, Fig. 10 is a cross-sectional view of a main part of the electronic circuit module according to the third embodiment of the present invention, and Fig. 11 is an explanation view showing a method for fabricating the circuit board, according to the third embodiment of the electronic circuit module of the present invention.

Then, the structure of the electronic circuit module according to the first embodiment of the present invention will be described with reference to Figs. 1 to 3. Referring to Figs. 1 to 3, a rectangular circuit board 1 formed from laminated plurality of insulating sheets has a plurality of concave portions 1c which is formed at corner portions on the upper surface 1a and which does not break through the lower surface 1b, and stopping portions 1d for plugging the lower portions of the concave portions 1c.

The concave portions 1c are formed with notches provided in side surfaces 1e disposed on an outer circumference of the circuit board 1, and outside surfaces 1f of the stopping portions 1d are flush with the side surfaces 1e of the circuit board 1.

Further, the circuit board 1 is composed of ceramics formed by a low temperature baking or thermoplastic resins made of glass epoxy based materials, and comprises a first board portion 2a provided with the concave portions 1c and a second board portion 2b provided with the stopping portions 1d which have body portions at positions corresponding to the lower portions of the concave portions 1c, wherein the circuit board 1 is made by laminating the first board portion 2a and the second board portion 2b.

Each of the first and second board portions 2a and 2b is formed by laminating a single insulating sheet or a plurality of insulating sheets, and on the circuit board 1 formed of the first and second board portions 2a and 2b, a blind via hole (non-through hole) 1g and a through hole 1h are provided.

In other words, the blind via hole 1g is formed by boring a through hole provided at the single insulating sheet or the plurality of the insulating sheets constituting the first board portion 2a, and the through hole 1h is formed by boring a hole which passes through all of the insulating sheets constituting the first and second board portions 2a and 2b.

Further, on the upper surface 1a of the circuit board 1 and different lamination positions between laminated layers, wiring patterns 3 are formed, and on an inner wall of the blind via hole 1g, an electric conductor 4 is provided, whereby wiring patterns 3 formed on the different lamination positions are connected to each other.

Further, on an inner wall of the through hole 1h, a conductor 5 is provided, and then the wiring patterns 3 formed on different lamination positions are connected to each other. Further, on the lower surface 1b, a connection conductor 6 connected to the conductor 5 is provided, and then the connection conductor 6 becomes a connection land to an external circuit.

Moreover, on the inner wall of the concave portions 1c, the electrode portions 7 are provided, and then the electrode portions 7 (not shown) are configured to be connected to a ground wiring pattern provided on the upper surface 1a or between the laminated layers.

On the wiring patterns 3 provided on the upper surface 1a of the circuit board 1 having such a structure, various electronic components 8, such as a chip type capacitor or resistor, are mounted, whereby a desired electric circuit is formed.

The box-shaped cover 9 made of a metal plate has an upper surface plate 9a, four side surface plates 9b bent downward from four sides of the upper surface plates 9a, and four attaching legs 9c extending downward from the side surface plates 9b.

The cover 9 is attached to the circuit board 1, covering the upper surface 1a of the circuit board 1 and the electronic components 8, in which the attaching legs 9c are inserted into the concave portions 1c, the lower edges of the side surface plates 9b are abutted to the upper surface 1a, and the attaching legs 9c are soldered to the electrode portions 7.

Moreover, in this embodiment, although the side surface plates 9b are abutted to the upper surface 1a, the lower edges of the attaching legs 9c may be abutted to the stopping portions 1d.

At this time, since the stopping portions 1d are provided to plug the lower portions of the concave portions 1c, a soldering connecting the attaching legs 9c to the electrode portions 7 is prevented from leaking to the lower surface 1b side of the circuit board 1 by the stopping portions 1d. Therefore, the soldering does not protrude downward from the lower surface 1b.

Further, since the lower portions of the concave portions 1c are plugged by the stopping portions 1d, the usable area of the lower surface 1b of the circuit board 1 is maximized, miniaturization of the circuit board 1 can be achieved, and the gap of the connection conductor 6 can be large.

The electronic circuit module having such a structure is configured such that the lower surface 1b of the circuit board 1 is positioned on the motherboard 10, and the connection conductor 6 provided in the lower surface 1b is soldered and connected to the circuit (not shown) of the motherboard 10.

In addition, when the circuit board 1 is positioned on the motherboard 10, the soldering connection the attaching legs 9c to the electrode portions 7 is prevented from leaking to the lower surface 1b side by the stopping portions 1d, and the soldering does not protrude from the lower surface 1b, so that a flatness of the circuit board 1 to the motherboard 10 is good, and a reliable connection is possible.

Next, a method for fabricating the circuit board 1 of the electronic circuit module according to the first embodiment of the present invention will be explained with reference to Figs. 4 and 5. Firstly, as shown in Fig. 4, a first large board 12 made of a single insulating sheet or laminated plurality of insulating sheets 11 and a second large board 14 made of a single sheet or laminated plurality of insulating sheets 13 are prepared.

Then, in the first large board 12, circular-shaped through holes 12a for forming the concave portions 1c in the corner portions are provided. Further, the second large board 14 is configured to have body portions for plugging the lower portions of the through holes 12a.

Next, as shown in Fig. 5, after being laminated, the first and second large boards 12 and 14 are cut along the cutting lines Z1 and Z2 positioned on the through holes 12a, so that a plurality of the circuit boards 1 having the concave portions 1c and the stopping portions 1d plugging the lower portions of the concave portions 1c are formed.

Then, when the first and the second large boards 12 and 14 are cut, the outside surfaces 1f of the stopping portions 1d are flush with the side surfaces 1e of the circuit board 1, and the concave portions 1c are formed in the side surfaces 1e of the corner portions which are positioned on the outer circumference of the circuit board 1.

Further, Figs. 6 and 7 show the electronic circuit module according to a second embodiment of the present invention. The structure of the second embodiment is configured such that concave portions 1c are provided on side surfaces 1e spaced away from the corner portions, and stopping portions 1d are provided to plug the lower portions of the concave portions 1c.

Since the other members are the same as those of the first embodiment, these have the same reference numerals as those of the first embodiment and thus the descriptions will be omitted herein.

Then, a method for fabricating the circuit board 1 of the electronic circuit module according to the second embodiment of the present invention will be explained with reference to Fig. 8. Referring to Fig. 8, a first large board 12 in which circular-shaped through holes 12a for forming the concave portions 1c at positions spaced away from the corner portions are provided, and a second large board 14 in which the body portions for plugging the lower portions of the through holes 12a are provided are laminated, and then the first and second large boards 12 and 14 are cut along the cutting lines Z1 and Z2 positioned on the through holes 12a. As a result, a plurality of the circuit board 1 having the concave portions 1c and the stopping portions 1d plugging the lower portions of the concave portions 1c are fabricated.

Then, when the first and second large boards 12 and 14 are cut, outside surfaces 1f of the stopping portions 1d are flush with the side surfaces 1e of the circuit board 1, and the concave portions 1c are formed in the side surfaces 1e which are disposed on the outer circumference spaced away from the corner portions of the circuit board 1.

Further, Figs. 9 and 10 show the electronic circuit module according to a third embodiment of the present invention. The structure of the third embodiment is configured such that concave portions 1c are provided inboard from the side surfaces 1e (spaced away from the side surfaces 1e), and stopping portions 1d plugging the lower portions of the concave portions 1c are provided.

That is, the concave portions 1c are composed of non-through holes, and are configured that a spare portion 1j is formed in the circuit board 1 outside the concave portions 1c (side surface 1e side).

Since the other members are the same as those of the first embodiment, these have the same reference numerals as those of the first embodiment and thus the descriptions will be omitted herein.

Then, a method for fabricating the circuit board 1 of the electronic circuit module according to the third embodiment of the present invention will be explained with reference to Fig. 11. Referring to Fig. 11, a first large board 12 in which circular-shaped through holes 12a for forming the concave portions 1c at positions spaced away from the side surfaces 1e are provided, and a second large board 14 in which the body portions for plugging the lower portions of the through holes 12a are provided are laminated, and then the first and second large boards 12 and 14 are cut along the cutting lines Z1 and Z2 positioned to the outside of the through holes 12a. As a result, a plurality of the circuit board 1 having the concave portions 1c and the stopping portions 1d plugging the lower portions of the concave portions 1c are fabricated.

Then, when the first and second large board 12 and 14 are cut, the circuit board 1 having the spare portion 1j lying to the outside of the concave portions 1c is formed.

## Claims

1. An electronic circuit module, comprising:
a circuit board formed with laminated plurality of insulating sheets, on an upper surface on which wiring patterns are formed;
an electronic component mounted on an upper surface of the circuit board;
concave portions provided in the circuit board;
electrode portions provided on inner walls of the concave portions; and
a cover made from a metal plate and having attaching legs soldered to the electrode portions in the concave portions in a state of covering the electronic component,
wherein the concave portions are formed toward a lower surface side from the upper surface of the circuit board,
wherein stopping portions for plugging the lower portions of the concave portions are provided in the circuit board, and
wherein the attaching legs of the cover are soldered to the electrode portions in a state of being inserted into the concave portions.

2. The electronic circuit module according to claim 1,
wherein the concave portions are formed with notches provided in a side surface on an outer circumference of the circuit board.

3. The electronic circuit module according to claim 2,
wherein the outside surfaces of the stopping portions for plugging the lower portions of the concave portions are flush with the side surface of the circuit board.

4. The electronic circuit module according to any of claims 1 to 3,
wherein the concave portions are formed with non-through holes provided inboard from the side surface of the circuit board.

5. The electronic circuit module according to any of claims 1 to 4,
wherein the circuit board comprises a first board portion having the concave portions which pass through the circuit board vertically, and a second board portion, on which the stopping portions are provided, having body portions at positions corresponding to the lower portions of the concave portions, and
wherein the circuit board is made by laminating the first board portion and the second board portion.

6. The electronic circuit module according to any of claims 1 to 5,
wherein a connection conductor connected to the wiring patterns are provided on the lower surface of the circuit board, and the circuit board is connected to a circuit on a motherboard via the connection conductor in a state of being mounted on the motherboard.

7. The electronic circuit module according to any of claims 1 to 6,
wherein the circuit board comprises a blind via hole and an electric conductor provided in an inner wall of the blind via hole, and the wiring patterns formed at different lamination positions are connected to each other via the electric conductor.
